# EUROPÄISCHE PATENTSCHRIFT

(11) **EP 1 102 320 B1**
(45) Veröffentlichungstag und Bekanntmachung des Hinweises auf die Patenterteilung: **20.08.2008**
(21) Anmeldenummer: 99122770.3
(22) Anmeldetag: 16.11.1999
(51) Int. Cl.: H01L 27/112, H01L 21/8246, G11C 17/12, H01L 27/02

(54) **Sicherheits-ROM-Speicherzelle und Verfahren zu deren Herstellung**
Security ROM memory cell and manufacturing method therefor
Cellule de mémoire ROM de securité et son procédé de fabrication

(43) Veröffentlichungstag der Anmeldung: 23.05.2001
(73) Patentinhaber: Infineon Technologies AG, 81669 München (DE)
(72) Erfinder: Nolles, Jürgen, 81541 München (DE); Walter, Georg, 80639 München (DE)
(74) Vertreter: Epping - Hermann - Fischer

(56) Entgegenhaltungen:
- EP-A- 0 378 306
- US-A- 5 258 334
- PATENT ABSTRACTS OF JAPAN vol. 1999, no. 01, 29. Januar 1999 (1999-01-29) & JP 10 270562 A (NIPPON TELEGR &TELEPH CORP <NTT>), 9. Oktober 1998 (1998-10-09)

## Beschreibung

Die vorliegende Erfindung bezieht sich auf eine Sicherheits-ROM-Speicherzelle und ein Verfahren zu deren Herstellung, wobei insbesondere ein Schutz vor optischen Angriffen zum Auslesen von gespeicherten Informationen realisiert ist.

Insbesondere durch die wachsende Verbreitung von Chipkarten, und sogenannten Smartcards beispielsweise für das elektronische Bargeld sowie für die verschiedensten Zugangsberechtigungen steigt der Bedarf nach sicheren Halbleiterschaltungen, die gegenüber Angriffen zum Auslesen bzw. Manipulieren der in derartigen Halbleiterschaltungen abgelegten Informationen geschützt sind. Derartige sicherheitsrelevante Daten können beispielsweise in ROM-Speicherzellen bzw. einer entsprechenden ROM-Matrixanordnung abgelegt werden, wobei ein Auslesen derartiger Informationen zuverlässig verhindert werden muß.

Zum Verhindern eines unautorisierten elektrischen Zugriffs auf die in derartigen ROM-Speicherzellen abgelegten Informationen sind eine Vielzahl von herkömmlichen Sicherheitsschaltungen bekannt, bei denen insbesondere ein elektrisches Auslesen durch einen nicht autorisierten Benutzer verhindert wird.

Ein derartiger Angriff durch nicht autorisierte Benutzer kann jedoch auch mittels optischer Verfahren durchgeführt werden, wobei ein Angreifer den Umstand ausnutzt, daß jede programmierte ROM-Speicherzelle eine mehr oder weniger optisch sichtbare Programmierung aufweist.

Zum Schutze derartiger sicherheitsrelevanter Halbleiterschaltungen sind eine Vielzahl von physikalischen Verfahren bekannt, bei denen der Halbleiterbaustein beispielsweise mit speziellen Umhüllungen umgeben wird, die beim Entfernen den Baustein zerstören. Andererseits werden derartige sicherheitsrelevante Bausteine mit feinen Drähten eingewickelt, wodurch ein Eingriff zuverlässig verhindert werden kann. Nachteilig bei derartigen herkömmlichen Sicherheitsvorkehrungen sind jedoch die relativ hohen Kosten sowie die Schwierigkeit bei der Verwendung in Einzel-Baustein-Lösungen wie z. B. Chipkarten und Smartcards.

Aus der EP-A- 0 378 306 ist eine Anordnung mit einer optischen Schutzschicht zum Verhindern eines optischen Erfassens eines Programmierelements non einer Oberseite des Halbleitersubstrats bekannt.

Der Erfindung liegt daher die Aufgabe zugrunde, eine Sicherheits-ROM-Speicherzelle sowie ein dazugehöriges Herstellungsverfahren zu schaffen, bei dem ein optisches Auslesen der in den ROM-Speicherzellen abgelegten Informationen zuverlässig und auf kostengünstige Art und Weise verhindert wird.

Erfindungsgemäß wird diese Aufgabe hinsichtlich der Speicherzelle durch die Merkmale des Patentanspruchs 1 und hinsichtlich des Verfahrens durch die Maßnahmen des Patentanspruchs 9 gelöst.

Insbesondere durch die Verwendung einer ersten und zweiten optische Schutzschicht zum Verhindern eines optischen Erfassens eines Programmierelements von einer Oberseite und einer Unterseite eines Halbleitersubstrats kann einem optischen Angriff zum Auslesen der in der Speicherzelle abgelegten Informationen zuverlässig entgegengewirkt werden.

Vorzugsweise stellt die erste und zweite optische Schutzschicht ohnehin vorhandene Funktionselemente bzw. Schichten der ROM-Speicherzelle dar, wodurch keine weiteren Prozeßschritte für die Herstellung der optischen Schutzschichten benötigt und die Herstellungskosten verringert werden. Die für das Ablegen der Daten benötigten Programmierelemente können sich hierbei in einer der vorhandenen Metallisierungsschichten, einer Kanalschicht und/oder einer vergrabenen Schicht befinden. Auf diese Weise können sowohl Anforderungen hinsichtlich einer hohen Integrationsdichte als auch hinsichtlich einer relativ späten Programmierung erfüllt werden.

In den weiteren Unteransprüchen sind weitere vorteilhafte Ausgestaltungen der Erfindung gekennzeichnet.

Die Erfindung wird nachstehend anhand von Ausführungsbeispielen unter Bezugnahme auf die Zeichnung näher beschrieben.

Es zeigen:
- Figur 1: ein vereinfachtes elektrisches Ersatzschaltbild eines ROM-Speichers mit einer Vielzahl von ROM-Speicherzellen;
- Figur 2: eine vereinfachte Schnittansicht einer Sicherheits-ROM-Speicherzelle gemäß einem ersten Ausführungsbeispiel;
- Figur 3: eine vereinfachte Draufsicht der Sicherheits-ROM-Speicherzelle gemäß dem ersten Ausführungsbeispiel;
- Figur 4: eine vereinfachte Schnittansicht einer Sicherheits-ROM-Speicherzelle gemäß einem zweiten Ausführungsbeispiel; und
- Figur 5: eine vereinfachte Schnittansicht einer Sicherheits-ROM-Speicherzelle gemäß einem dritten Ausführungsbeispiel.

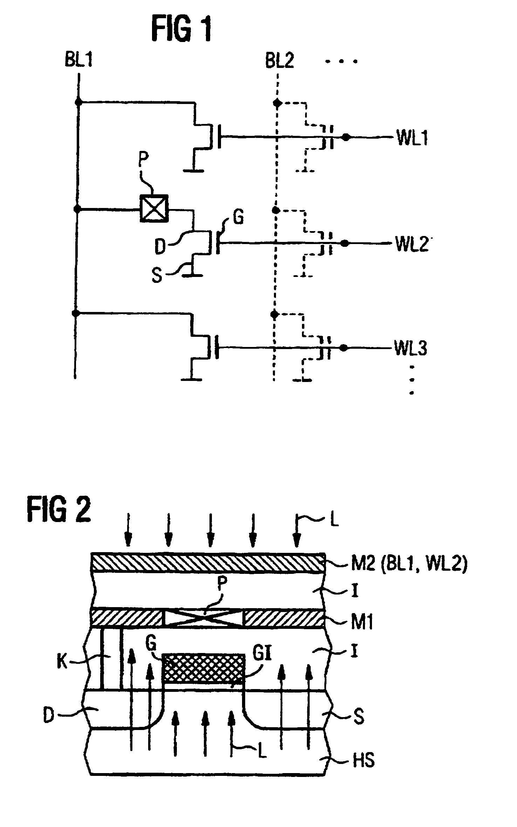

Figur 1 zeigt eine vereinfachte Darstellung eines elektrischen Ersatzschaltbilds eines ROM-Speichers mit einer Vielzahl von ROM-Speicherzellen. Gemäß Figur 1 bestehen die einzelnen Speicherzellen aus Feldeffekttransistoren (FET) mit einem Gate G, einem Drain D und einer Source S. Die Source S ist beispielsweise an Masse angeschlossen, während das Drain D der jeweiligen Feldeffekttransistoren an eine gemeinsame Bitleitung BL1, BL2 usw. angeschlossen ist. Andererseits werden die jeweiligen Gates G der Speicherzellen zeilenweise mit entsprechenden Wortleitungen WL1, WL2 und WL3 verbunden, wodurch sich der in Figur 1 dargestellte matrixförmige Aufbau ergibt. Die vorliegende Erfindung ist jedoch nicht auf den in Figur 1 dargestellten matrixförmigen Aufbau mit Feldeffekttransistoren beschränkt sondern umfaßt vielmehr auch weitere Strukturen wie z. B. serielle Anordnung von Schaltelementen, die beispielsweise auch aus Bipolartransistoren oder Dioden bestehen können.

Eine Programmierung einer jeweiligen Speicherzelle erfolgt bei den in Figur 1 dargestellten Feldeffekttransistoren im wesentlichen auf drei verschiedene Arten. Einerseits kann die Information durch Programmierung, d. h. Verbindung oder Unterbrechung einer Drain-Zuleitung erfolgen, wobei ein Programmierelement P z.B. in einer Metallisierungsschicht für das Drain D ausgebildet ist. Wird beispielsweise das Programmierelement P als Teil einer Metallisierungsschicht entfernt so ist der entsprechende Feldeffekttransistor zu keinem Zeitpunkt mit der Bitleitung BL1 verbunden und liefert bei entsprechender Anschaltung der Wortleitungen WL1 bis WL3 den logischen Wert 1 an die Bitleitung 1. Andererseits wird bei Vorhandensein des Programmierelements P der Feldeffekttransistor bei entsprechender Anschaltung durch die Wortleitungen WL1 bis WL3 mit der Masse verbunden, so daß an der Bitleitung BL1 eine logische Null ausgelesen wird. Auf diese Weise lassen sich die jeweiligen Speicherzellen mit unterschiedlichen Informationsgehalten programmieren.

Alternativ zu der in Figur 1 dargestellten Programmierung über ein in einer Zuführungsleitung (Metallisierungsschicht) realisiertes Programmierelement P, kann sich dieses auch in einer Kanalschicht unterhalb des Gates G oder in einer vergrabenen Schicht im Halbleitersubstrat befinden, wodurch wiederum ein Schaltverhalten des als Schaltelement dienenden Feldeffekttransistors verändert wird und damit Informationen bzw. Daten abgelegt werden können.

Figur 2 zeigt eine vereinfachte Schnittansicht einer in Figur 1 dargestellten Sicherheits-ROM-Speicherzelle. Gemäß Figur 2 sind an der Oberfläche eines Halbleitersubstrats HS ein Draingebiet D und ein Sourcegebiet S ausgebildet. Oberhalb eines zwischen dem Draingebiet D und dem Sourcegebiet S ausgebildeten Kanals befindet sich eine Gate-Isolationsschicht GI, die beispielsweise aus SiO₂ besteht, und ein darüber angeordnetes Gate, welches vorzugsweise aus einem hochdotierten Polysilizium besteht. Oberhalb des Gates G befindet sich durch eine Isolationsschicht I beabstandet eine erste Metallisierungsschicht M1, die unmittelbar oberhalb des Gates G ein Programmierelement P aufweist. Genauer gesagt wird die Speicherzelle beispielsweise durch Entfernen der Metallisierung innerhalb des durch das Programmierelement P definierten Bereichs unterbrochen, wodurch sich der Informationsgehalt für die ROM-Speicherzelle ergibt. Oberhalb der ersten Metallisierungsschicht M1 wird durch eine weitere Isolationsschicht I eine zweite Metallisierungsschicht M2 ausgebildet, die üblicherweise eine Bitleitung BLx darstellt, jedoch auch eine Wortleitung WLx mit x = 1 bis n darstellen kann.

Wesentlich für die Erfindung ist nunmehr die Anordnung des Programmierelements P zwischen dem Gate G und der zweiten Metallisierungsschicht M2. Da sowohl die zweite Metallisierungsschicht M2 als auch das hochdotierte Polysilizium des Gates G eine optisch dichte Schutzschicht darstellen, wird ein Angriff mittels optischer Verfahren beispielsweise durch Licht L von der Oberseite und/oder der Unterseite des Halbleitersubstrats HS zuverlässig verhindert. Das Programmierelement P befindet sich demzufolge immer im Schatten einer optischen Schutzschicht (Gate G oder zweite Metallisierungsschicht M2), wodurch ein Auslesen des Speicherinhalts beispielsweise mittels eines Mikroskops zuverlässig verhindert wird.

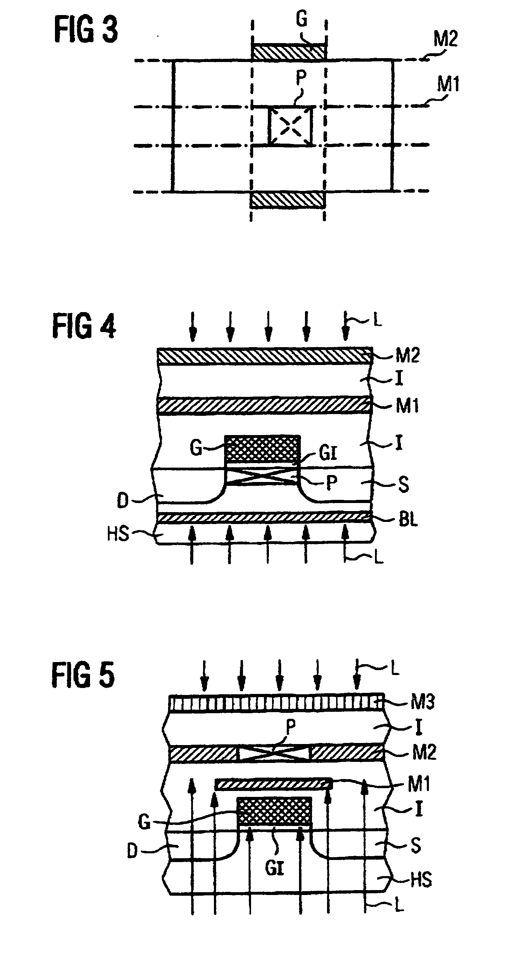

Figur 3 zeigt eine Draufsicht der Sicherheits-ROM-Speicherzelle gemäß dem ersten Ausführungsbeispiel, wobei gleiche Bezugszeichen gleiche Schichten bzw. Elemente der ROM-Speicherzelle kennzeichnen. Demzufolge befindet sich das Programmierelement P, welches in der ersten Metallisierungsschicht M1 ausgebildet werden kann, unmittelbar unter der zweiten Metallisierungsschicht M2, die diese vollständig verdeckt bzw. eine optische Barriere darstellt. Andererseits wird ein optisches Auslesen von der Unterseite beispielsweise mittels Durchlicht durch die hochdotierte Polysiliziumschicht des Gates G verhindert, wodurch ein optischer Angriff von beiden Seiten zuverlässig verhindert werden kann.

Darüber hinaus stellt die Sicherheits-ROM-Speicherzelle gemäß dem ersten Ausführungsbeispiel eine besonders kostengünstige Lösung dar, da ohnehin vorhandene Funktionselemente wie z. B. die zweite Metallisierungsschicht M2 für die Bitleitung BLx und die Polysiliziumschicht für die jeweiligen Gates G ohnehin vorhanden sind.

Ein weiterer Vorteil der Sicherheits-ROM-Speicherzelle gemäß dem ersten Ausführungsbeispiel besteht darin, daß eine Programmierung der Speicherinhalte in einer relativ hohen Ebene, d. h. erste Metallisierungsebene M1, durchgeführt wird, wodurch eine Zeitspanne zwischen einer Auftragsvergabe und der Auslieferung der jeweiligen Schaltung mit Sicherheits-ROM-Speicherzelle wesentlich verkürzt werden kann. Beispielsweise können derartige Wafer bis zur ersten Metallisierungsschicht M1 bereits vorgefertigt werden, wobei die eigentliche Programmierung nur noch mittels Ätzen der Programmierelemente P und Aufbringen der weiteren Metallisierungsschicht bzw. Schichten abgeschlossen wird.

Figur 4 zeigt eine Sicherheits-ROM-Speicherzelle gemäß einem zweiten Ausführungsbeispiel, wobei gleiche Bezugszeichen gleiche oder ähnliche Schichten bzw. Elemente bezeichnen.

Gemäß Figur 4 ist in einem Halbleitersubstrat HS wiederum ein Feldeffekttransistor mit einem Gate G, einem Drain D und einer Source S ausgebildet. Im Gegensatz zur Sicherheits-ROM-Speicherzelle gemäß dem ersten Ausführungsbeispiel wird jedoch bei diesem zweiten Ausführungsbeispiel das Programmierelement P im Kanal unmittelbar unter der Gate-Isolierschicht GI beispielsweise mittels Ionenimplantation ausgebildet, wodurch der entsprechende Feldeffekttransistor unabhängig von seiner Gate-Ansteuerung immer leitend ist. Alternativ könnte das Programmierelement P auch in einer tiefer gelegenen vergrabenen Schicht (buried layer) ausgebildet werden und beispielsweise unterhalb des Kanals das Drain-Gebiet D mit dem Source-Gebiet S leitend verbinden.

Zur Realisierung der zweiten optischen Schutzschicht zum Verhindern eines optischen Auslesens von der Unterseite des Halbleitersubstrats HS mit Durchlicht L ist beispielsweise im Halbleitersubstrat eine vergrabene optische Schutzschicht BOL (buried optical layer) ausgebildet, die entweder eine reflektierende oder eine absorbierende Wirkung hinsichtlich des von unten eingestrahlten Durchlichts L aufweist.

Zur Verhinderung eines optischen Auslesens der Information bzw. des Zustands des Programmierelements P dient gemäß Figur 4 entweder die zweite Metallisierungsschicht M2, die erste Metallisierungsschicht M1 oder das Gate G des Feldeffekttransistors. Dadurch ergibt sich eine wesentliche Vereinfachung für das Layout der Metallisierungsschichten M1 und M2, da das Gate G ohnehin ein Auslesen der Daten von der Oberseite des Halbleitersubstrats zuverlässig verhindert.

Selbst wenn eine derartige Programmierung der Sicherheits-ROM-Speicherzelle in einem relativ frühen Herstellungsschritt - beispielsweise mittels Diffusion oder Implantation - eine relativ große Zeitspanne zwischen einer Auftragsvergabe durch den Kunden und der Auslieferung der endgültigen Schaltung zur Folge hat, können auf diese Weise wesentlich kleinere Strukturen und damit höhere Integrationsdichten (≤ 0,25 Mikrometer) realisiert werden.

Figur 5 zeigt eine vereinfachte Schnittansicht einer Sicherheits-ROM-Speicherzelle gemäß einem dritten Ausführungsbeispiel, wobei wiederum gleiche Bezugszeichen gleiche oder ähnliche Schichten bzw. Elemente bezeichnen. Im Gegensatz zur Sicherheits-ROM-Speicherzelle gemäß dem ersten Ausführungsbeispiel besitzt die in Figur 5 dargestellte Speicherzelle eine weitere Metallisierungsschicht, d. h. dritte Metallisierungsschicht M3, wodurch komplexere Halbleiterschaltungen realisiert werden können. Vorzugsweise befindet sich gemäß Figur 5 das Programmierelement P in der zweiten Metallisierungsschicht M2 unmittelbar unterhalb der dritten Metallisierungsschicht M3, die als optische Schutzschicht ein Auslesen bzw. optisches Erfassen des Programmierelement P von einer Oberseite des Halbleitersubstrats zuverlässig verhindert. Von der Unterseite des Halbleitersubstrats HS wird das Programmierelement P beispielsweise durch die erste Metallisierungsschicht M1 oder das Gate G vor einem Auslesen bzw. optischen Erfassen geschützt.

Üblicherweise werden die Maße des Programmierelements P bei den vorstehend beschriebenen Ausführungsbeispielen auf den vom jeweils verwendeten Fertigungsprozeß vorgegebenen Minimalwert reduziert. Bei den heute üblichen Minimalgrößen bzw. Strukturgrößen von ≤ 0,25 Mikrometer ist die optische Auflösungsgrenze herkömmlicher Lichtmikroskope bereits erreicht, weshalb eine untere Schutzschicht bei Verwendung von sichtbarem Licht L entfallen kann, da das Licht an der oberen Metallisierungsschicht M1 bis M3 reflektiert wird und ein von unten eingestrahltes Licht (Durchlicht) nur die größere Struktur der oberen Metallisierungsebene aufzulösen vermag. Die in der darunter liegenden Metallisierungsschicht ausgebildeten Informationen bzw. Programmierelemente P bleiben somit verborgen.

Ferner kann unterhalb des Programmierelements P eine Low-Resist-Polysiliziumschicht ausgebildet werden (hochdotiert), die das Gate G des Feldeffekttransistors kontaktiert. Da Silizium Licht unterhalb einer Wellenlänge von 700 nm absorbiert, kommen für eine abbildende Analyse nur die Wellenlängen ≥700 nm in Frage. Um derartige Wellenlängen zu absorbieren, werden daher hochdotierte Siliziumschichten genutzt, die in diesem Wellenlängenbereich eine starke Absorptionsfähigkeit aufweisen. Die starke Absorptionsfähigkeit macht dadurch ein Erkennen von Strukturen oberhalb der hochdotierten Polysiliziumschicht unmöglich.

Die Erfindung wurde vorstehend anhand von reflektierenden Metallisierungsschichten und absorbierenden hochdotierten Polysiliziumschichten für die optischen Schutzschichten beschrieben. Sie ist jedoch nicht darauf beschränkt und umfaßt vielmehr alle weiteren optischen Schutzschichten, die ein optisches Erfassen der Programmierelemente P verhindern.

Insbesondere kann anstelle der für das Gate verwendeten hochdotierten Polysiliziumschicht auch eine leitende Metallisierung mit ihrer optimalen Reflexionseigenschaft verwendet werden. In gleicher Weise kann anstelle der Metallisierungsschichten eine oder mehrere Polysiliziumschichten mit ihren optimalen Absorptionseigenschaften verwendet werden.

## Patentansprüche

1. Sicherheits-ROM-Speicherzelle mit
einem Halbleitersubstrat (HS);
einem auf und/oder im Halbleitersubstrat (HS) ausgebildeten Schaltelement (G, D, S); und
einem Programmierelement (P) zum Programmieren des Schaltverhaltens des Schaltelements (G, D, S),
eine erste optische Schutzschicht (M2; M3) zum Verhindern eines optischen Erfassens des Programmierelements (P) von einer Oberseite des Halbleitersubstrats (HS),
**gekennzeichnet durch**
eine zweite optische Schutzschicht (G; BOL) zum Verhindern eines optischen Erfassens des Programmierelements (P) von einer Unterseite des Halbleitersubstrats (HS).

2. Sicherheits-ROM-Speicherzelle nach Patentanspruch 1,
**dadurch gekennzeichnet, daß** die erste und/oder zweite optische Schutzschicht (M2, G) anderweitige Funktionselemente der ROM-Speicherzelle darstellen.

3. Sicherheits-ROM-Speicherzelle nach Patentanspruch 1 oder 2,
**dadurch gekennzeichnet, daß** die erste und/oder zweite optische Schutzschicht eine hochdotierte Polysiliziumschicht oder Metallisierungsschicht darstellt.

4. Sicherheits-ROM-Speicherzelle nach einem der Patentansprüche 1 bis 3,
**dadurch gekennzeichnet, daß** das Schaltelement einen Feldeffekttransistor mit einem Gate (G), einer Source (S) und einem Drain (D) darstellt.

5. Sicherheits-ROM-Speicherzelle nach einem der Patentansprüche 1 bis 4,
**dadurch gekennzeichnet, daß** die erste optische Schutzschicht in einer zweiten oder dritten Metallisierungsschicht (M2; M3), die zweite optische Schutzschicht in einer Gateschicht (G) und das Programmierelement (P) in einer ersten oder zweiten Metallisierungsschicht (M1; M2) ausgebildet ist.

6. Sicherheits-ROM-Speicherzelle nach Patentanspruch 4,
**dadurch gekennzeichnet, daß** das Programmierelement (P) in einer Kanalschicht des Feldeffekttransistors ausgebildet ist.

7. Sicherheits-ROM-Speicherzelle nach einem der Patentansprüche 4 oder 6,
**dadurch gekennzeichnet, daß** das Programmierelement (P) in einer vergrabenen Schicht des Halbleitersubstrats (HS) ausgebildet ist.

8. Chipkarte mit einer Vielzahl von Sicherheits-ROM-Speicherzellen gemäß einem der Patentansprüche 1 bis 7.

9. Verfahren zur Herstellung einer Sicherheits-ROM-Speicherzelle mit den Schritten:
a) Ausbilden eines Feldeffekttransistors mit einem optisch dichten Gate (G), einer Source (S) und einem Drain (D) auf einem Halbleitersubstrat (HS);
b) Ausbilden einer Isolierschicht (I) zumindest über dem Gate (G);
c) Ausbilden eines Programmierelements (P) in einer ersten leitenden Schicht (M1) unmittelbar über dem optisch dichten Gate (G);
d) Ausbilden einer weiteren Isolierschicht (I) zumindest über dem Programmierelement (P); und
e) Ausbilden einer weiteren leitenden Schicht (M2), die zumindest unmittelbar über dem Programmierelement (P) optisch dicht ist.

10. Verfahren nach Patentanspruch 9,
**dadurch gekennzeichnet, daß** beim Ausbilden des optisch dichten Gates (G) des Feldeffekttransistors hochdotiertes Polysilizium verwendet wird.

11. Verfahren nach Patentanspruch 9 oder 10,
**dadurch gekennzeichnet, daß** das Ausbilden des Programmierelements (P) im Halbleitersubstrat (HS) durch Ionenimplantation oder Diffusion erfolgt und eine optische Schutzschicht (BOL) unterhalb des implantierten Programmierelements (P) ausgebildet ist.

## Claims

1. Security ROM memory cell comprising
a semiconductor substrate (HS);
a switching element (G, D, S) formed on and/or in the semiconductor substrate (HS); and
a programming element (P) for programming the switching behaviour of the switching element (G, D, S),
a first optical protective layer (M2; M3) for preventing an optical detection of the programming element (P) from a top side of the semiconductor substrate (HS),
**characterized by**
a second optical protective layer (G; BOL) for preventing an optical detection of the programming element (P) from an underside of the semiconductor substrate (HS).

2. Security ROM memory cell according to Patent Claim 1,
**characterized in that** the first and/or second optical protective layer (M2, G) represent other functional elements of the ROM memory cell.

3. Security ROM memory cell according to Patent Claim 1 or 2,
**characterized in that** the first and/or second optical protective layer represents a highly doped polysilicon layer or metallization layer.

4. Security ROM memory cell according to any of Patent Claims 1 to 3,
**characterized in that** the switching element represents a field effect transistor having a gate (G), a source (S) and a drain (D).

5. Security ROM memory cell according to any of Patent Claims 1 to 4,
**characterized in that** the first optical protective layer is formed in a second or third metallization layer (M2; M3), the second optical protective layer is formed in a gate layer (G) and the programming element (P) is formed in a first or second metallization layer (M1; M2).

6. Security ROM memory cell according to Patent Claim 4,
**characterized in that** the programming element (P) is formed in a channel layer of the field effect transistor.

7. Security ROM memory cell according to either of Patent Claims 4 and 6,
**characterized in that** the programming element (P) is formed in a buried layer of the semiconductor substrate (HS).

8. Chip card comprising a multiplicity of security ROM memory cells according to any of Patent Claims 1 to 7.

9. Method for producing a security ROM memory cell comprising the following steps:
a) forming a field effect transistor having an optically dense gate (G), a source (S) and a drain (D) on a semiconductor substrate (HS);
b) forming an insulating layer (I) at least above the gate (G);
c) forming a programming element (P) in a first conductive layer (M1) directly above the optically dense gate (G);
d) forming a further insulating layer (I) at least above the programming element (P); and
e) forming a further conductive layer (M2), which is optically dense at least directly above the programming element (P).

10. Method according to Patent Claim 9,
**characterized in that** highly doped polysilicon is used when forming the optically dense gate (G) of the field effect transistor.

11. Method according to Patent Claim 9 or 10,
**characterized in that** the programming element (P) is formed in the semiconductor substrate (HS) by ion implantation or diffusion and an optical protective layer (BOL) is formed below the implanted programming element (P).

## Revendications

1. Cellule de mémoire ROM de sécurité, comprenant
un substrat (HS) semi-conducteur ;
un élément (G, D, S) de commutation formé sur et/ou dans le substrat (HS) semi-conducteur ; et
un élément (P) de programmation pour programmer le comportement de commutation de l'élément (G, D, S) de commutation,
une première couche (M2 ; M3) optique de protection pour empêcher une détection optique de l'élément (P) de programmation par la face supérieure du substrat (HS) semi-conducteur,
**caractérisée par** une deuxième couche (G ; POL) optique de protection pour empêcher une détection optique de l'élément (P) de programmation par une face inférieure du substrat (HS) semi-conducteur.

2. Cellule de mémoire ROM de sécurité suivant la revendication 1,
**caractérisée en ce que** la première et/ou la deuxième couche (M2, G) optique de protection constituent par ailleurs des éléments fonctionnels de la cellule de mémoire ROM.

3. Cellule de mémoire ROM de sécurité suivant la revendication 1 ou 2,
**caractérisée en ce que** la première et/ou la deuxième couche optique de protection constituent une couche de polysilicium très dopé ou une couche de métallisation.

4. Cellule de mémoire ROM de sécurité suivant l'une des revendications 1 à 3,
**caractérisée en ce que** l'élément de commutation constitue un transistor à effet de champ ayant une grille (G), une source (S) et un drain (D).

5. Cellule de mémoire ROM de sécurité suivant l'une des revendications 1 à 4,
**caractérisée en ce que** la première couche optique de protection est formée dans une deuxième ou troisième couche (M2 ; M3) de métallisation, la deuxième couche optique de protection dans une couche (G) de grille et l'élément (P) de programmation dans une première ou deuxième couche (M1 ; M2) de métallisation.

6. Cellule de mémoire ROM de sécurité suivant la revendication 4,
**caractérisée en ce que** l'élément (P) de programmation est formé dans une couche de canal du transistor à effet de champ.

7. Cellule de mémoire ROM de sécurité suivant l'une des revendications 4 ou 6,
**caractérisée en ce que** l'élément (P) de programmation est formé dans une couche enfouie du substrat (HS) semi-conducteur.

8. Carte à puce ayant une pluralité de cellules de mémoire ROM de sécurité suivant l'une des revendications 1 à 7.

9. Procédé de production d'une cellule de mémoire ROM de sécurité comprenant les stades dans lesquels :
a) on forme un transistor à effet de champ ayant une grille (G) opaque, une source (S) et un drain (D) sur un substrat (HS) semi-conducteur ;
b) on forme une couche (I) isolante au moins au-dessus de la grille (G) ;
c) on forme un élément (P) de programmation dans une première couche (M1) conductrice juste au-dessus de la grille (G) opaque ;
d)on forme une autre couche (I) isolante au moins au-dessus de l'élément (P) de programmation ; et
e) on forme une autre couche (M2) conductrice qui est opaque au moins juste au-dessus de l'élément (P) de programmation.

10. Procédé suivant la revendication 9,
**caractérisé en ce que,** lors de la formation de la grille (G) opaque du transistor à effet de champ, on utilise du polysilicium très dopé.

11. Procédé suivant la revendication 9 ou 10,
**caractérisé en ce qu'**on effectue la formation de l'élément (P) de programmation dans le substrat (HS) semi-conducteur par implantation d'ions ou par diffusion, et une couche (BOL) optique de protection est formée en dessous de l'élément (P) de programmation implanté.
